# EUROPEAN PATENT APPLICATION

(11) **EP 2 278 859 A1**
(43) Date of publication of application: **26.01.2011**
(21) Application number: 09728402.0
(22) Date of filing: 11.03.2009
(51) Int. Cl.: H05B 33/10, H01L 51/50, H05B 33/12, H05B 33/22

(54) **METHOD FOR MANUFACTURING ORGANIC ELECTROLUMINESCENCE ELEMENT, ORGANIC ELECTROLUMINESCENCE ELEMENT AND DISPLAY DEVICE**

(30) Priority: 31.03.2008 JP 2008091563
(71) Applicant: Sumitomo Chemical Company, Limited, Tokyo 104-8260 (JP)
(72) Inventor: ROKUHARA, Kouichi, Shimotsuma-shi Ibaraki 304-0823 (JP)
(74) Representative: Duckworth, Timothy John
(86) International application number: PCT/JP2009/054629
(87) International publication number: WO 2009/122874

(57) **Abstract**

A method of producing an organic electroluminescent element according to the present invention is a method of producing an organic electroluminescent element by stacking on a substrate at least a cathode, an anode, and an organic light-emitting layer disposed between the cathode and the anode. The method of the present invention is **characterized by** comprising: an organic light-emitting layer forming step of forming the organic light-emitting layer by applying an ink comprising an organic light-emitting material to an inside of a partition wall built to surround a pixel region for forming a pixel; and a surface treating step of treating a surface before the organic light-emitting layer forming step with an organic solvent from the side where the partition wall is built with respect to the substrate. According to the method of the present invention, the organic light-emitting layer can be formed without film defects, and a high-quality organic electroluminescent element and a high-quality display device having the organic electroluminescent element are provided.

## Description

### TECHNICAL FIELD

The present invention relates to a method of producing an organic electroluminescent element (hereinafter, an organic electroluminescent element may be referred to as an organic EL element), to an organic EL element obtained using the production method, and to a display device comprising the organic EL element.

### BACKGROUND ART

An organic EL element has a basic structure, as is well known, comprising a first electrode (an anode or cathode), a second electrode (a cathode or anode), and an organic light-emitting layer provided between these electrodes. In such a structure, when a current is allowed to flow between the electrodes facing each other with the organic light-emitting layer interposed therebetween, the organic light-emitting layer emits light.

A display device using organic EL elements generally uses a display panel formed by arranging a large number of organic EL elements in a matrix form, each of which functions as a pixel. In such a display panel, its first electrodes are formed in a fine pattern to provide a large number of pixels, and partition walls for forming the large number of pixel regions are formed in grid-like form over the patterned first electrodes. The partition walls are formed by forming a photoresist film on the first electrode pattern and patterning the photoresist film using photolithography. The first electrodes are exposed in inner regions surrounded by the large number of partition walls, and these regions serve as the pixel regions in some cases.

Ink repellency is imparted to the surfaces of the large number of partition walls by forming them using a photoresist material containing an ink repellant (water repellant) material or by, after the formation of the partition walls, coating their surfaces selectively with an ink repellant material. The organic light-emitting layer is then formed on the pixel regions. However, one or two or more organic material layers (interlayers) may be formed before the formation of the organic light-emitting layer.

Although a vacuum deposition method could be used as the method of forming the organic light-emitting layer on each pixel region so as to have a thickness of in the order of 100 nm, a wet coating method is generally used because the light-emitting layer can be made (formed) efficiently with high precision. In the wet coating method, an organic light-emitting material is dissolved in a solvent to prepare a coating solution, and the coating solution is applied selectively to the pixel regions. For applying selectively, a printing method such as a relief printing method or an ink-jet printing method is used.

For example, a method disclosed in Patent Document 1 is known as one conventional method of forming an organic light-emitting layer using the relief printing method. The method disclosed in Patent Document 1 is characterized by comprising: imparting ink repellency to the surfaces of the partition walls by adding an ink repellent material into a photoresist compound used as a partition wall material; and forming an organic light-emitting layer by selectively applying coating solutions of organic light-emitting materials by relief printing to the pixel regions partitioned by the ink repellent partition walls.

Patent Document 1 describes that the following operational effects can be obtained by the disclosed method of forming an organic light-emitting layer.
By imparting ink repellency to the partition walls, an organic material layer (a hole transport layer in Patent Document 1), which is formed before the formation of the organic light-emitting layer, can be formed by coating the entire surface of a substrate with an organic material ink (hole transport ink) at a time. More specifically, even when the entire surface of the substrate, including the surfaces of the partition walls, is coated with the hole transport ink at a time, the hole transport ink applied to the surfaces of the partition walls is repelled therefrom and flows into each pixel region, so that the surfaces of the partition walls remain uncoated. Therefore, when each organic light-emitting ink for forming the organic light-emitting layer, which is formed after the formation of the hole transport layer, is applied to the pixel regions by relief printing, the partition walls could be coated with the organic light-emitting ink; however, the ink is repelled from the ink repellent surfaces of the partition walls. Accordingly color mixing of organic light-emitting materials in adjacent pixel regions can be prevented.

Patent Document 1: JP 2006-286243 A

### DISCLOSURE OF THE INVENTION

### PROBLEMS TO BE SOLVED BY THE INVENTION

As described in Patent Document 1, the method of forming an organic light-emitting layer by applying organic light-emitting inks using a relief printing method to pixel regions partitioned by partition walls having ink repellent surfaces is suitable for efficiently producing an organic EL element. However, studies by the present inventors have revealed that such a method has the following problems to be solved.

When an organic light-emitting ink is selectively applied to pixel regions by, for example, relief printing, the organic light-emitting ink can be repelled from the peripheral edges of the pixel regions and the pixel regions themselves. Therefore, some portions are not coated with the organic light-emitting ink, so that the organic light-emitting ink is not applied over the entire pixel regions. In such a case, the total area of the pixel regions that actually emit light can be not greater than a design value. The amount of light emitted from a pixel with coating failure may be not greater than a design value. In some cases, such a pixel may not emit light. This results in uneven light emission, and the quality of light emission is significantly reduced.

The present invention has been achieved in view of the above circumferences. It is an object of the invention to provide a method of producing an organic EL element that can form an organic light-emitting layer without film defects. It is also an object of the invention is to provide an organic EL element obtained using the production method and a display device comprising the organic EL element.

### MEANS FOR SOLVING THE PROBLEM

To solve the above problems, the present invention provides a method of producing an organic EL element, an organic EL element obtained using the production method, and a display device comprising the organic EL element, configured as described below.

[1] A method of producing an organic electroluminescent element in which at least a cathode, an anode, and an organic light-emitting layer located between the cathode and the anode are stacked on a substrate, the method comprising:
an organic light-emitting layer forming step of forming the organic light-emitting layer by applying an ink comprising an organic light-emitting material to the inside of a partition wall built to surround a pixel region for forming a pixel; and
a surface treating step of treating a surface before the organic light-emitting layer forming step with an organic solvent from the side where the partition wall is built with respect to the substrate.

[2] The method of producing an organic electroluminescent element according to the above [1], wherein the step of treating the surface is a step of bringing the organic solvent into contact with the surface from the side where the partition wall is built with respect to the substrate.

[3] The method of producing an organic electroluminescent element according to the above [2], wherein the organic solvent is brought into contact with the surface from the side where the partition wall is built with respect to the substrate, by using a spin coating method, in the step of treating the surface.

[4] The method of producing an organic electroluminescent element according to the above [2] or [3], wherein the step of treating the surface comprises drying the organic solvent after the organic solvent is brought into contact with the surface.

[5] The method of producing an organic electroluminescent element according to any one of the above [1] to [4], wherein the organic solvent comprises one or two or more of solvents for an ink.

[6] The method of producing an organic electroluminescent element according to any one of the above [1] to [5], wherein the organic solvent comprises one or two or more of solvents for the organic light-emitting material.

[7] The method of producing an organic electroluminescent element according to the above [5] or [6], wherein the organic solvent is anisole.

[8] The method of producing an organic electroluminescent element according to any one of the above [1] to [7], wherein the ink comprising the organic light-emitting material is applied to the inside of the partition wall by a printing method, in the step of forming the organic light-emitting layer.

[9] The method of producing an organic electroluminescent element according to the above [8], wherein the printing method is a flexographic printing method.

[10] The method of producing an organic electroluminescent element according to any one of the above [1] to [9], further comprising an interlayer forming step of forming an organic material layer in the pixel region before the surface treating step.

[11] An organic electroluminescent element obtained by the method of producing an organic electroluminescent element according to any one of the above [1] to [10].

[12] A display device comprising the organic electroluminescent element according to the above [11].

### EFFECT OF THE INVENTION

In the method of producing an organic EL element according to the present invention, before an ink including an organic light-emitting material (hereinafter, this may be referred to as an organic light-emitting ink) is applied to the inside of a partition wall, the surface to be coated with the organic light-emitting ink is treated with an organic solvent to moderate ink repellency. This effectively improves a coating property when the organic light-emitting ink is applied thereto, resulting in a significant reduction in defects in the coating of the organic light-emitting ink. Therefore, according to the present invention, an organic EL element and a display device that are reduced in unevenness of light emission from their light-emitting surfaces and have a good light emitting property can be obtained.

### BEST MODE(S) FOR CARRYING OUT THE INVENTION

As described above, the method of producing an organic EL element according to the present invention is a method of producing an organic electroluminescent element in which at least a cathode, an anode, and an organic light-emitting layer disposed between the cathode and the anode are stacked on a substrate. The method is characterized by comprising: an organic light-emitting layer forming step of forming the organic light-emitting layer by applying an ink comprising an organic light-emitting material to the inside of a partition wall built to surround a pixel region for forming a pixel; and a surface treating step of treating a surface before the organic light-emitting layer forming step with an organic solvent from the side where the partition wall is built with respect to the substrate.
The structure of the organic EL element produced by the method of the present invention is described below, and then the method of producing the organic EL element according to the present invention is described in more detail.

### (Substrate)

As the substrate for the organic EL element, any substrate that is unchanged when the electrodes and the organic material layer are formed may be used. Examples of such a substrate may include glass, plastic, polymer film, and silicon substrates and stacked bodies thereof. Also, a substrate which is obtained by subjecting a plastic, polymer, or similar film to treatment for reducing water permeability, may be used. As the substrate, a commercially available substrate may be used, and also the substrate may be prepared by a known method.

### (Electrodes and light-emitting layer)

he organic EL element is formed by stacking at least an anode, a cathode, and an organic light-emitting layer located between the cathode and anode. At least one of the anode and the cathode is a transparent electrode having light transmittance property. A low-molecular and/or a macromolecular organic light-emitting material is used for the light-emitting layer.

In the organic EL element, a plurality of light-emitting layers may be provided between the anode and the cathode, and a layer other than the light-emitting layer may be provided between the anode and the cathode. Hereinafter, a layer provided between the cathode and the light-emitting layer may be referred to as a cathode-side interlayer, and a layer provided between the anode and the light-emitting layer may be referred to as an anode-side interlayer.

Examples of the anode-side interlayer provided between the anode and the light-emitting layer may include a hole injection layer, a hole transport layer, and an electron blocking layer.

The hole injection layer has a function of improving hole injection efficiency from the cathode. The hole transport layer has a function of improving hole injection from a hole injection layer or a layer (hole transport layer) closer to the anode. When the hole injection layer or the hole transport layer has a function of blocking transport of electrons, these layers may be referred to as electron blocking layers. Whether or not these layers have a function of blocking transport of electrons can be determined, for example, by producing an element that allows only electron current to flow therethrough and measuring the reduction in the current value to examine the effects of blocking.

Examples of the cathode-side interlayer provided between the cathode and the light-emitting layer include an electron injection layer, an electron transport layer, and a hole blocking layer.

The electron injection layer has a function of improving electron injection efficiency from the cathode. The electron transport layer has a function of improving electron injection from the electron injection layer or a layer (electron transport layer) closer to the cathode. When the electron injection layer or the electron transport layer has a function of blocking transport of holes, these layers may be referred to as hole blocking layers. Whether or not these layers have a function of blocking transport of holes can be determined, for example, by producing an element that allows only hole current to flow therethrough and measuring the reduction in the current value to examine the effects of blocking.

Examples of the layered structure of the layers provided between the anode and cathode may include: a structure in which a hole transport layer is provided between the anode and the light-emitting layer; a structure in which an electron transport layer is provided between the cathode and the light-emitting layer; and a structure in which an electron transport layer is disposed between the cathode and the light-emitting layer and also a hole transport layer is provided between the anode and the light-emitting layer. Specific examples may include the following layered structures of a) to d):
a) anode/light-emitting layer/cathode;
b) anode/hole transport layer/light-emitting layer/cathode;
c) anode/light-emitting layer/electron transport layer/cathode; and
d) anode/hole transport layer/light-emitting layer/electron transport layer/cathode.
   (The symbol "/" means that the layers are stacked adjacent to each other. The same is applied to the following description.)

In the above structures, the light-emitting layer has a function of emitting light; the hole transport layer has a function of transporting holes; and the electron transport layer has a function of transporting electrons, as described above. The electron transport layer and the hole transport layer may be collectively referred to as charge transport layers. Two or more light-emitting layers, two or more hole transport layers, or two or more electron transport layer may be used independently. Among the charge transport layers provided adjacent to the electrodes, a layer having the function of improving charge injection efficiency from an electrode and the effect of reducing the driving voltage of the element may be particularly referred to as a charge injection layer (hole injection layer or electron injection layer).

To improve an adhesion property with an electrode or a charge injection property from the electrode, the charge injection layer or an insulating layer having a thickness of 2 nm or less may be provided adjacent to the electrode. To improve an adhesion property or to prevent mixing of the interface, a thin buffer layer may be inserted into the interface of the charge transport layers or the light-emitting layers. The order, the number, and the thicknesses of the stacked layers may be appropriately set in consideration of light emitting efficiency and the life of the element.

Examples of the organic EL element having a charge injection layer (electron injection layer, hole injection layer) may include: an organic EL element including a charge injection layer provided adjacent to the cathode; and an organic EL element including a charge injection layer provided adjacent to the anode. Specific examples may include the following structures of e) to p):
e) anode/charge injection layer/light-emitting layer/cathode;
f) anode/light-emitting layer/charge injection layer/cathode;
g) anode/charge injection layer/light-emitting layer/charge injection layer/cathode;
h) anode/charge injection layer/hole transport layer/light-emitting layer/cathode;
i) anode/hole transport layer/light-emitting layer/charge injection layer/cathode;
j) anode/charge injection layer/hole transport layer/light-emitting layer/charge injection layer/cathode;
k) anode/charge injection layer/light-emitting layer/charge transport layer/cathode;
l anode/light-emitting layer/electron transport layer/charge injection layer/cathode;
m) anode/charge injection layer/light-emitting layer/electron transport layer/charge injection layer/cathode;
n) anode/charge injection layer/hole transport layer/light-emitting layer/charge transport layer/cathode;
o) anode/hole transport layer/light-emitting layer/electron transport layer/charge injection layer/cathode; and
p) anode/charge injection layer/hole transport layer/light-emitting layer/electron transport layer/charge injection layer/cathode.

### (Anode)

As the above anode, for example, a thin film of a metal oxide, metal sulfide, or metal, which has high electric conductivity, may be use as a transparent electrode or a semi-transparent electrode. A thin film having high light-transmittance is preferably used. A suitable thin film is appropriately selected depending on the organic layer used. Specific examples of the thin films may include a thin film of indium oxide, zinc oxide, tin oxide, indium-tin oxide (abbreviated as ITO), indium-zinc oxide (abbreviated as IZO), gold, platinum, silver, copper. Among them, ITO, IZO, and tin oxide are preferably used.

Examples to be used as the anode may include organic transparent conductive films made of polyaniline or derivatives thereof, and polythiophene or derivatives thereof. In addition, a thin film obtained from a mixture containing at least one selected from the group consisting of a material used for the organic transparent conductive films, a metal oxide, a metal sulfide, a metal, a carbon material such as carbon nanotubes may be used as the anode.

For the anode, a material that reflects light may also be used, and preferred examples of such a material may include metals, metal oxides, and metal sulfides having a work function of 3.0 eV or more.

Examples of the method of producing the anode may include a vacuum deposition method, a sputtering method, an ion plating method, and a plating method.

The thickness of the anode may be appropriately selected in consideration of its light transmittance and electric conductivity. The thickness is, for example, 5 nm to 10 µm, preferably 10 nm to 1 µm, and more preferably 20 nm to 500 nm.

### (Anode-side interlayer)

An anode-side interlayer such as a hole injection layer or a hole transport layer is stacked between the anode and the light-emitting layer, if necessary, as described in the above.

### (Hole injection layer)

The hole injection layer may be provided between the anode and the hole transport layer or between the anode and the light-emitting layer, as described in the above. No particular limitation is imposed on the material that forms the hole injection layer, and any known material may be appropriately used. Examples of such a material may include phenylamine-based materials, starburst amine-based materials, phthalocyanine-based materials, hydrazone derivatives, carbazole derivatives, triazole derivatives, imidazole derivatives, oxadiazole derivatives having amino groups, oxides such as vanadium oxide, tantalum oxide, tungsten oxide, molybdenum oxide, ruthenium oxide, and aluminum oxide, amorphous carbon, polyaniline, and polythiophene derivatives.

The thickness of the hole injection layer is preferably about 5 to about 300 nm. When the thickness is less than 5 nm, its production tends to be difficult. When the thickness exceeds 300 nm, the driving voltage and the voltage applied to the hole injection layer tend to be large.

### (Hole transport layer)

No particular limitation is imposed on the material that forms the hole transport layer. Examples of such a material may include: aromatic amine derivatives such as N,N'-diphenyl-N,N'-di(3-methylphenyl)4,4'-diaminobiphenyl (TPD) and 4,4'-bis[N-(1-naphthyl)-N-phenylamino]biphenyl (NPB); polyvinylcarbazole and derivatives thereof; polysilane and derivatives thereof; polysiloxane derivatives having an aromatic amine in their side chain or main chain; pyrazoline derivatives; arylamine derivatives; stilbene derivatives; triphenyldiamine derivatives; polyaniline and derivatives thereof; polythiophene and derivatives thereof; polyarylamine and derivatives thereof; polypyrrole and derivatives thereof; poly(p-phenylene vinylene) and derivatives thereof; and poly(2,5-thienylene vinylene) and derivatives thereof.

Among them, polymer hole transport materials are preferably used as the hole transport material used for the hole transport layer. Examples of such polymer hole transport materials include polyvinylcarbazole and derivatives thereof, polysilane and derivatives thereof, polysiloxane derivatives having an aromatic amine compound group in their side chain or main chain, polyaniline and derivatives thereof, polythiophene and derivatives thereof, polyarylamine and derivatives thereof, poly(p-phenylene vinylene) and derivatives thereof, and poly(2,5-thienylene vinylene) and derivatives thereof. Specifically, polyvinylcarbazole and derivatives thereof, polysilane and derivatives thereof, and polysiloxane derivatives having an aromatic amine in their side chain or main chain are more preferably used. When a low-molecular hole transport material is used, it is preferable that the transport material is dispersed in a macromolecular binder.

No particular limitation is imposed on the thickness of the hole transport layer. The thickness may be appropriately changed according to the intended design and is preferably about 1 to about 1000 nm. When the thickness is less than the lower limit, its production tends to be difficult, or sufficient effects of hole transport tend not to be obtained. When the thickness exceeds the above upper limit, the driving voltage and the voltage applied to the hole transport layer tend to be large. Therefore, the thickness of the hole transport layer is preferably 1 to 1000 nm, as described above, more preferably 2 nm to 500 nm, and more preferably 5 nm to 200 nm.

### (Organic light-emitting layer)

The organic light-emitting layer usually contains an organic material (a low molecular compound or a macromolecular compound) that mainly emits fluorescence or phosphorescence. The organic light-emitting layer may further contain a dopant material. Examples of the material that forms the organic light-emitting layer used in the present invention may include the following dye-based materials, metal complex-based materials, polymer-based materials, and dopant materials.

Examples of the dye-based materials may include cyclopendamine derivatives, tetraphenyl butadiene derivative compounds, triphenylamine derivatives, oxadiazole derivatives, pyrazoloquinoline derivatives, distyrylbenzene derivatives, distyrylarylene derivatives, quinacridone derivatives, coumarin derivatives, pyrrole derivatives, thiophene ring compounds, pyridine ring compounds, perinone derivatives, perylene derivatives, oligothiophene derivatives, oxadiazole dimer, and pyrazoline dimer.

Examples of the metal complex-based materials may include: metal complexes that emit light from a triplet excitation state such as iridium complexes and platinum complexes; and metal complexes such as an aluminum quinolinol complex, a benzoquinolinol beryllium complex, a benzoxazolyl zinc complex, a benzothiazole zinc complex, an azomethyl zinc complex, a porphyrin zinc complex, and europium complexes, which are complexes having a central metal such as Al, Zn, Be, and a rare earth metal such as Tb, Eu and Dy, and a ligand such as oxadiazole, thiadiazole, phenylpyridine, phenylbenzimidazole, and a quinoline structure.

Examples of the polymer-based materials may include poly-p-phenylene vinylene derivatives, polythiophene derivatives, poly-p-phenylene derivatives, polysilane derivatives, polyacetylene derivatives, polyfluorene derivatives, polyvinylcarbazole derivatives, and polymerized products of the above dye-based materials and metal complex-based light-emitting materials.

Among the above organic light-emitting layer-forming materials, examples of blue light-emitting materials may include distyrylarylene derivatives and polymerized products thereof, oxadiazole derivatives and polymerized products thereof, polyvinylcarbazole derivatives, poly-p-phenylene derivatives, and polyfluorene derivatives. Among them, polymer materials such as polyvinylcarbazole derivatives, poly-p-phenylene derivatives, and polyfluorene derivatives are preferred.

Among the above organic light-emitting layer-forming materials, examples of green light-emitting materials may include quinacridone derivatives and polymerized products thereof, coumarin derivatives and polymerized products thereof, poly-p-phenylene vinylene derivatives, and polyfluorene derivatives. Among them, polymer materials such as poly-p-phenylene vinylene derivatives and polyfluorene derivatives are preferred.

Among the above light-emitting layer-forming materials, examples of red light-emitting materials may include coumarin derivatives and polymerized products thereof, thiophene ring compounds and polymerized products thereof, poly-p-phenylene vinylene derivatives, polythiophene derivatives, and polyfluorene derivatives. Among them, polymer materials such as poly-p-phenylene vinylene derivatives, polythiophene derivatives, and polyfluorene derivatives are preferred.

For the purpose of, for example, improving the light emitting efficiency or changing the wavelength of emitted light, a dopant may be added to the organic light-emitting layer. Examples of the dopant may include perylene derivatives, coumarin derivatives, rubrene derivatives, quinacridone derivatives, squalium derivatives, porphyrin derivatives, styryl-based dyes, tetracene derivatives, pyrazolone derivatives, decacyclene, and phenoxazone.
The thickness of such an organic light-emitting layer is usually 2 nm to 200 nm.

### (Cathode-side interlayer)

A cathode-side interlayer such as an electron injection layer or an electron transport layer is stacked between the light-emitting layer and the cathode described later, if necessary, as described in the above.

### (Electron transport layer)

For forming the electron transport layer, a known material may be used. Examples of such a material may include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, 8-hydroxyquinoline and metal complexes of derivatives thereof, polyquinoline and derivatives thereof, polyquinoxaline and derivatives thereof, and polyfluorene and derivatives thereof.

Among them, oxadiazole derivatives, benzoquinone and derivatives thereof, anthraquinone and derivatives thereof, 8-hydroxyquinoline and metal complexes of derivatives thereof, polyquinoline and derivatives thereof, polyquinoxaline and derivatives thereof, and polyfluorene and derivatives thereof are preferably used. More preferably, 2-(4-biphenylyl)-5-(4-t-butylphenyl)-1,3,4-oxadiazol, benzoquinone, anthraquinone, tris(8-quinolinol)aluminum, and polyquinoline are used.

### (Electron injection layer)

The electron injection layer is provided between the electron transport layer and the cathode or between the light-emitting layer and the cathode, as described in the above. The electron injection layer is selected according to the type of the light-emitting layer, and examples of the electron injection layer may include alkali metals; alkaline-earth metals; alloys containing at least one of the above metals; oxides, halides, and carbonates of the above metals; and mixtures of these materials.

Examples of the alkali metals and the oxides, halides, and carbonates thereof may include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate.

Examples of the alkaline-earth metals and the oxides, halides, and carbonates thereof may include magnesium, calcium, barium, strontium, magnesium oxide, magnesium fluoride, calcium oxide, calcium fluoride, calcium fluoride, barium oxide, barium fluoride, strontium oxide, strontium fluoride, and magnesium carbonate.

Organic metal compounds doped with metals, metal oxides, and metal salts, organic metal complex compounds, and mixtures thereof may also be used as the material for the electron injection layer.

The electron injection layer may have a layered structure formed by stacking two or more layers. Specific examples of the laminate may include Li/Ca. The electron injection layer is formed by, for example, vapor deposition, sputtering, or a printing method.
The thickness of the electron injection layer is preferably about 1 nm to about 1 µm.

### (Cathode)

For the material for the cathode, a material which has a small work function and can easily inject electrons to the light-emitting layer and/or a material having high electric conductivity and/or a material having high reflectivity of visible light are preferred. Specific examples of the cathode material may include metals, metal oxides, alloys, graphite, intercalated graphite, and inorganic semiconductors such as zinc oxide (ZnO).

Examples of the above metals may include alkali metals, alkaline-earth metals, transition metals, and group 13 metals in the periodic table. Specific examples of the metals may include lithium, sodium, potassium, rubidium, cesium, beryllium, magnesium, calcium, strontium, barium, gold, silver, platinum, copper, manganese, titanium, cobalt, nickel, tungsten, tin, aluminum, scandium, vanadium, zinc, yttrium, indium, cerium, samarium, europium, terbium, and ytterbium.

Examples of the alloys may include alloys containing at least one of the above metals. Specific examples of the alloys may include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

The cathode is a transparent electrode or a semi-transparent electrode, if necessary. Examples of the material for the cathode may include: conductive oxides such as indium oxide, zinc oxide, tin oxide, ITO, and IZO; and conductive organic materials such as polyaniline and derivatives thereof and polythiophene and derivatives thereof.

The cathode may have a layered structure having two or more layers. The electron injection layer may be used as the cathode.

The thickness of the cathode is appropriately selected in consideration of electrical conductivity and durability. The thickness is, for example, 10 nm to 10 µm, preferably 20 nm to 1 µm, and more preferably 50 nm to 500 nm.

### (Upper sealing film)

After the cathode is formed in the manner described above, an upper sealing film for protecting a light-emitting function unit having a basic structure of anode/light-emitting layer/cathode is formed so as to seal the light-emitting function unit. The upper sealing film usually includes at least one inorganic layer and at least one organic layer. The number of stacked layers is determined as appropriate. The inorganic layers and the organic layers are basically stacked alternately.

Even if the light-emitting function unit is covered with a substrate and the upper sealing film, the light-emitting material in the organic light-emitting layer is easily oxidized and also easily degraded in contact with water since the plastic substrate has higher permeability of gas and liquid than that of the glass substrate. Therefore, when a plastic substrate is used as the substrate, a lower sealing film having high barrier property against gas and liquid is stacked on the plastic substrate, and then the light-emitting function unit is stacked on the lower sealing film. The lower sealing film usually has a structure similar to the structure of the upper sealing film and is formed of a material similar to the material for the upper sealing film.

### [Method of producing organic EL element]

Hereinafter, the method of producing an organic EL element according to the present invention is described in more detail.

### (Anode forming step)

A substrate formed of any of the above substrate materials is prepared. When a plastic substrate having high permeability of gas and liquid is used, a lower sealing film is formed on the substrate in advance, if necessary.

Next, an anode is formed and patterned on the prepared substrate by using any of the above anode materials. When the anode is a transparent electrode, any of the above transparent electrode materials such as ITO, IZO, tin oxide, zinc oxide, indium oxide, and zinc-aluminum complex oxide is used. When ITO, for example, is used, the patterned electrode is formed by forming a uniform deposition film on the substrate by the sputtering method and then patterning the uniform film into a line pattern by photolithography.

### (Partition wall forming step)

After the line-patterned anode is formed, a photosensitive material is applied to the substrate having the anode formed thereon to stack a photoresist film. Next, the photoresist film is patterned into a grid-like form by photolithography to form insulating partition walls. Rectangular regions surrounded by the grid-like form of partition walls are pixel regions, and the patterned anodes are exposed in the pixel regions.

The insulating photosensitive material that forms the insulating partition wall may be a positive resist or a negative resist. It is important that the partition wall has the insulating property. When the partition wall does not have the insulating property, current likely flows between different pixels, and this causes a display defect.

Specific examples of the photosensitive material that forms the partition wall may include polyimide-based, acrylic resin-based, and novolac resin-based photosensitive compounds. To improve the display quality of the organic EL element, a material having light-blocking property may be added to the photosensitive material.

To impart ink repellency to the surface of the insulating partition wall, an ink repellent material may be added to the photosensitive material for forming the partition wall. Alternatively, after the insulating partition wall is formed, the surface thereof may be coated with an ink repellent material to impart ink repellency to the surface of the partition wall. It is preferable that the ink repellency can also work to both inks for the interlayers and for the organic light-emitting layer, as described later.

Examples of the ink repellent compound used when the ink repellent material is added to the photosensitive material may include silicone-based compounds and fluorine-containing compounds. Such ink repellent compounds are preferred because they exhibit ink repellency to both the organic light-emitting ink (coating solution, described later) used for forming the organic light-emitting layer and the organic material inks (coating solutions, described later) for the interlayers such as a hole transport layer.

Examples of the method of forming the ink repellent coating on the surface of the formed partition wall may include: a method in which a coating solution containing an ink repellent component is applied to the surfaces of the partition walls; a method in which the functional groups of an organic material on the surfaces of the partition walls are substituted with fluorine to modify the surfaces; and a method in which an ink repellent component is vaporized and deposited on the surface of the partition wall. Specific examples of the deposition method using a vapor phase method, described the above, may include a plasma treatment using CF₄ gas as an introduction gas. The partition wall of an organic material is more easily fluorinated by CF₄ gas than the substrate and the electrodes. Therefore, ink repellency may be selectively imparted to the surface of the partition wall by plasma treatment.

The photosensitive material (photoresist composition) for forming the insulating partition wall may be applied by a coating method using, for example, a spin coater, a bar coater, a roll coater, a die coater, a gravure coater, or a slit coater. After curing, the coated film is patterned into a grid-like form having desired dimensions by commonly used photolithography.

### (Anode-side interlayer formation step)

After the insulating partition wall is formed, the method includes an interlayer formation step of forming an organic material layer in the pixel regions, if necessary, before the subsequent step of surface-treating. The organic material layer (anode-side interlayer) such as the hole transport layer described above is thereby formed.

No particular limitation is imposed on the method of forming the anode-side interlayer. Examples of the forming method using a low-molecular material may include a forming method using a solution mixture of the low-molecular material and a macromolecular binder. Examples of the forming method using a macromolecular material may include a deposition method using a solution.

No particular limitation is imposed on the solvent used for film formation using a solution, so long as the solvent can dissolve the material for the above-mentioned anode-side interlayer. Examples of such a solvent may include: chlorine-based solvents such as chloroform, methylene chloride, and dichloroethane; ether-based solvents such as tetrahydrofuran; aromatic hydrocarbon-based solvents such as toluene and xylene; ketone-based solvents such as acetone and methyl ethyl ketone; and ester-based solvents such as ethyl acetate, butyl acetate, and ethyl cellosolve acetate.

Examples of the method of film formation using a solution may include: coating methods using a solution such as spin coating, casting, micro-gravure coating, gravure coating, bar coating, roll coating, wire bar coating, dip coating, slit coating, capillary coating, spray coating, and nozzle coating methods; and printing methods such as gravure printing, screen sprinting, flexographic printing, offset printing, reverse printing, and ink-jet printing methods. Printing methods such as gravure printing, screen sprinting, flexographic printing, offset printing, reverse printing, and ink-jet printing methods are preferred since pattern formation is easy.

A mixed macromolecular binder that does not excessively inhibit charge transport is preferably used.
In addition, a macromolecular binder that absorbs only a small amount of visible light is preferably used. Examples of such a macromolecular binder may include polycarbonate, polyacrylate, polymethylacrylate, polymethylmethacrylate, polystyrene, polyvinylchloride, and polysiloxane.

When the coating solution is applied to the entire surface of the substrate using any of the above coating methods, the partition wall may be coated with the coating solution. Even in such a case, the coating solution on the partition wall is repelled from the ink-repellent surface of the partition wall, falls into the pixel region partitioned by the partition wall, and forms a coating film within each pixel region. The coating film within each pixel region is then dried and forms the interlayer to exert its function.

### (Surface-treating step)

In a conventional method of producing an organic EL element, the organic light-emitting layer is formed after the anode-side interlayer is formed if necessary, as described above. However, in the present invention, before the organic light-emitting layer is formed, a surface is treated with an organic solvent from the side where the partition wall is built with respect to the substrate (hereinafter, this surface may be referred to as a substrate surface having the partition wall).

The surface-treating step is performed by bringing the organic solvent into contact with the surface from the side where the partition wall is built with respect to the substrate. The organic solvent needs to be brought into contact with at least the surface of the partition wall. The organic solvent is not necessarily brought into contact with the entire surfaces of the substrate but is preferably brought into contact with the entire substrate surface on the side having the partition walls formed thereon.

Examples of the method of bringing the organic solvent into contact with the substrate surface may include: a spin coating method in which the substrate is rotated and the organic solvent is dripped onto the rotating substrate to allow the organic solvent to come in contact with the entire substrate surface; a method in which the substrate is inclined and the organic solvent is applied or sprayed to the inclined substrate; and a method in which the substrate is immersed in the organic solvent and is then pulled up therefrom. After the organic solvent is brought into contact with the entire substrate surface or with the partition wall and the surface of the pixel region by using any of the above methods, the organic solvent in contact with the surface is preferably dried so that the droplets of the organic solvent do not remain thereon. Examples of the drying method may include heat drying, air drying, and air blowing.

The organic solvent used is preferably one or a combination of two or more of the solvents for inks. Among the solvents for inks, one or a combination of two or more of the solvents for the organic light-emitting material (described later) is more preferably used. Specific examples of the solvent for the organic light-emitting material may include toluene, xylene, acetone, anisole, methyl ethyl ketone, methyl isobutyl ketone, cyclohexanone, and solvent mixtures thereof, and anisole is preferred.
The surface treatment with the organic solvent moderates the ink repellency of the surface of the partition wall to some extent, but the ink repellency is not lost. More specifically, even when the organic light-emitting ink is applied to the partition wall after the surface of the partition wall are treated with the organic solvent, the repellency of the partition wall to the organic light-emitting ink is not lost, and the partition wall still retain the required ink repellency.

### (Organic light-emitting layer formation step)

After the completion of the surface-treating step, the step of forming an organic light-emitting layer is performed. As the organic light-emitting material used for the organic light-emitting layer, the materials described above such as the macromolecular weight of organic light-emitting materials and/or any of the low-molecular weight of organic light-emitting materials are used.

When a macromolecular organic light-emitting material is used, a coating solution of the organic light-emitting material (organic light-emitting ink) is prepared by dissolving or stably dispersing the macromolecular material in a solvent. Examples of the solvent for dissolving or dispersing the organic light-emitting material may include: single solvents such as toluene, xylene, acetone, anisole, methyl ethyl ketone, methyl isobutyl ketone, and cyclohexanone; and any mixed solvents thereof. Among these, aromatic organic solvents such as toluene, xylene, and anisole are preferred because they have favorable dissolvability of the organic light-emitting material. If necessary, a surfactant, an antioxidant, a viscosity modifier, an UV absorber, and the like may be added to the ink of the organic light-emitting material.

The methods for applying a ink including a organic light-emitting material (organic light-emitting ink) to the inside of the partition wall may include the following. When the organic EL element emits monochromatic light used for a lighting device, it is not necessary to consider to apply selectively; therefore, any of coating methods such as spin coating, casting, micro-gravure coating, gravure coating, bar coating, roll coating, wire bar coating, dip coating, slit coating, capillary coating, spray coating, and nozzle coating methods may be used. When the organic EL element emits multi-color light used for a color display device, predetermined organic light-emitting inks need to be selectively applied to respective pixel regions to avoid color mixing. Examples of such methods may include printing methods such as gravure printing, screen printing, flexographic printing, offset printing, reverse printing, and ink-jet printing methods. Among them, to apply the organic light-emitting inks accurately to the inner regions of the partition walls, the ink-jet printing and flexographic printing methods are preferred. The flexographic printing method is particularly preferred.

With a conventional method, when an organic light-emitting ink is applied to the inside of the partition wall using any of the above methods, the coating solution could be repelled from the ink-repellent side surface of the partition wall and the surface of the anode or the anode-side interlayer, resulting in defects in the coating (coating unevenness). However, in the present invention, the surface-treating step by using the organic solvent is performed before the organic light-emitting layer forming step. The ink repellency is thereby moderated to an appropriate extent, so that the occurrence of coating unevenness is prevented. Therefore, the organic light-emitting ink is applied such that the entire surface of the pixel region is coated with the ink to a design value, and then coating is formed over the entire surfaces of the each pixel region. The organic light-emitting coating formed on the each pixel region without coating unevenness is to be the organic light-emitting layer through a drying step performed as appropriate, and the function of the organic light-emitting layer is thereby exerted.

### (Cathode-side interlayer formation step)

A cathode-side interlayer such as a hole transport layer or a hole injection layer is formed after the organic light-emitting layer is formed, if necessary.
No particular limitation is imposed on the method of forming the cathode-side interlayer when this interlayer is an electron transport layer. Examples of the method when a low-molecular electron transport material is used may include vacuum deposition using power and deposition from a solution or molten state material. Examples of the method when a macromolecular electron transport material is used may include deposition from a solution or molten state material. When deposition from a solution or molten state material is used, a macromolecular binder may also be used at the same time. To form the electron transport layer using a solution, a deposition method similar to any of the above-described methods of depositing the hole transport layer using a solution may be used.

The electron injection layer is formed using, for example, vacuum deposition, sputtering, or a printing method.

### (Cathode forming step)

The cathode is formed using any of the above-described materials by, for example, vacuum deposition, sputtering, a CVD method, ion plating, laser ablation, or a laminating method in which a metal thin film is bonded by thermal-compression.

After the cathode is formed in the manner described above, an upper sealing film is formed to protect the light-emitting function unit having a basic structure of anode/light-emitting layer/cathode. The upper sealing film may include at least one inorganic layer and at least one organic layer, if necessary. The number of the stacked layers is determined as appropriate, and the inorganic layers and the organic layers are basically stacked alternately.

The organic EL element in the present embodiment is useful as surface light sources, light sources for segment display devices and dot-matrix display devices, and backlights of liquid crystal display devices.

When the organic EL element in the present embodiment is used as a surface light source, the flat anode and cathode are disposed so as to overlap each other as viewed from a stacking direction.

Examples for the method of forming an organic EL element that is used as the light source of a segment display device and emits patterned light may include: a method in which a mask having a patterned window that allows light to pass therethrough is disposed on the surface light source; a method in which the organic layer is formed such that its extinction portions are formed to have an extremely large thickness to substantially prevent light from being emitted therefrom; and a method in which at least one of the anode and the cathode is formed into a pattern. A segment-type display device capable of displaying numbers, characters, and simple symbols can be achieved by forming organic EL elements that emit patterned light using any of these methods and wiring their electrodes such that voltage can be selectively applied to desired electrodes. To use the organic EL elements as the light source of a dot-matrix display device, for example, their anodes and cathodes are formed into stripes and arranged so as to be orthogonal to each other as viewed from a stacking direction.

Examples of methods to achieve a partial color or multicolor dot-matrix display may include a method of applying a plurality of light-emitting materials that emit different colors to different areas or a method of using a color filter, a fluorescent conversion filter or the like. These dot-matrix display devices may be driven passively or actively in combination with TFTs or the like.

These display devices are useful as a display device for a computer, a television set, a portable terminal, a mobile phone, a car navigation, a viewfinder of the video camera and the like.

The above planar light sources are of the thin self-light-emitting type, and are useful as backlights of liquid crystal display devices and planar light sources for lighting devices. When a flexible substrate is used, the organic EL element may be used as curved light sources or display devices.

### Examples

Examples of the present invention are shown below. The examples shown below are to describe the present invention through preferable ones, but they do not limit the present invention.

### (Example)

In the Example shown below, an organic EL element having a layered structure was used in which a hole injection layer was provided as an anode interlayer and no cathode interlayer was provided. The present invention is characterized by including the surface-treating step in which the surface of a substrate on which a partition wall has been formed is treated with an organic solvent. Therefore, the present invention is applicable to any types of organic EL elements having layered structures other than those shown in the Example described below, and similar operational effects can be obtained.

### (Preparation of substrate and formation of anodes)

First, an ITO thin film was formed on a transparent glass plate of 200 mm (length) x 200 mm (width) x 0.7 mm (thickness) and was patterned, thus forming stripe-shaped anodes. The repetition pitch of the anodes was 80 µm. The width of the anodes (lines) was 70 µm, and the spacing between the anodes was 10 µm (line:spacing = 70 µm:10 µm). As viewed from one thickness direction of the substrate, pixel regions in which pixels were formed were formed as islands on the ITO thin film extending in one direction, and the islands were spaced apart from each other by a predetermined spacing in the one direction.

### (Formation of partition walls)

Next, the entire surface of the substrate was spin-coated with a positive photoresist (product name "OFPR-800," product of Tokyo Ohka Kogyo Co., Ltd.), and the obtained coating was dried to form a photoresist layer having a thickness of 1 µm.
Next, a photo-mask designed so as to shield regions other than the pixel regions from UV rays as viewed from one thickness direction of the substrate was placed on the photoresist layer, and the photoresist layer was irradiated with UV rays from an alignment exposure apparatus (product name "MA1300," product of Dainippon Screen Mfg. Co., Ltd.) through the photo-mask (exposure step).
After the exposure step, the exposed portions of the photoresist layer were removed using a resist developer (product name "NMD-3," product of Tokyo Ohka Kogyo Co., Ltd.) (development step).
Then, the glass substrate was subjected to heat treatment on a hot plate at 230°C for 1 hour to completely heat-cure the developed photoresist layer (heat-curing step).
In the above photolithography steps, the partition walls (organic insulating layer) surrounding the pixel regions were formed, and the anode appeared within the inner regions of the partition walls. The width of the lines of the obtained partition walls was 20 µm, and their height was 2 µm. Each pixel region had a rectangular shape of 60 µm x 180 µm.

Next, the partition walls were subjected to ink repellent treatment in a vacuum plasma apparatus (product name "RIE-200L," product of SAMCO International Inc.) using CF₄ gas.

### (Formation of anode-side interlayer)

Next, a suspension of poly(3,4-ethylenedioxythiophene)/ polystyrene sulfonate (product name "BaytronP AI4083," product of Bayer) was filtrated through a 0.2 µm membrane filter. The filtrate was applied to the pixel regions using a nozzle coating method. Then the coating layer was subjected to heat treatment at 200°C for 20 minutes, thus forming a hole injection layer having a thickness of 60 nm.

### (Treatment of substrate surface on partition wall side with solvent)

Next, a total of 30 mL of anisole was continuously dripped onto the substrate, and anisole was brought into contact with (applied to) the entire surface of the substrate using a spin coating method. Then, the substrate was subjected to air blow treatment for about 30 minutes to dry the substrate.

### (Formation of organic light-emitting layer)

A polymer light-emitting material (product name "RP158," product of Sumation Co., Ltd) used as an organic light-emitting material was dissolved in a solvent mixture prepared by mixing anisole and cyclohexylbenzene in a weight ratio of 1:1, thus preparing an organic light-emitting ink (the concentration of the polymer light-emitting material: 1 percent by weight). The organic light-emitting ink (viscosity: 28 cp) was applied to the inside of the insulating partition wall that had been treated with anisole, using a flexographic printing method. The resultant coating film was dried, thus forming an organic light-emitting layer having a thickness of 60 nm in the pixel regions. The time after completion of the surface treatment with anisole until the printing using the organic light-emitting ink was started was about 30 minutes.

The conditions of the organic light-emitting layer formed on each pixel region were observed under an optical microscope (product name "OPTIPHOTO 88," product of Nikon Corporation, magnification of the objective lens: 50X). It was found that there was no evidence that the organic light-emitting ink was repelled from the partition wall and the anode-side interlayer and that the organic light-emitting layer was formed over the entire areas of the pixel regions.

### (Formation of cathode)

Next, calcium used as the cathode was evaporated onto the organic light-emitting layer to a thickness of 100 angstroms, and aluminum used as an oxidation protection layer was evaporated thereon to a thickness of 2000 angstroms. An organic EL element having a bottom emission structure was thereby produced.

When the organic EL element obtained as above was turned on to emit light, the light emitting intensity was uniform over its entire light-emitting surface.

### (Comparative Example)

An organic EL element was produced by the same procedure as in the above Example except that "the treatment of the substrate surface from the partition wall side with a solvent" before the formation of the organic light-emitting layer in the Example was not performed.

Immediately after the formation of the organic light-emitting layer, conditions of the organic light-emitting layer formed on each pixel region were observed under an optical microscope (product name "OPTIPHOTO 88," product of Nikon Corporation, magnification of the objective lens: 50X). It was found that some of the pixel regions inside of the partition walls have defective portions in which the organic light-emitting layer was not formed as viewed from one thickness direction of the substrate because the organic light-emitting ink was repelled from the partition wall and the surface of the anode-side interlayer.

When the organic EL element obtained in the Comparative Example was turned on to emit light, unevenness of light emission occurred on its light-emitting surface.

### INDUSTRIAL APPLICABILITY

As described above, according to the present invention of the method of a organic EL element, the organic EL element can be produced so that the formation area of the organic light-emitting layer does not fall below the designed value. With the method of producing an organic EL element according to the present invention, an organic EL element and a display device which are excellent in light-emitting characteristics can be obtained.

## Claims

1. A method of producing an organic electroluminescent element in which at least a cathode, an anode, and an organic light-emitting layer located between the cathode and the anode are stacked on a substrate, the method comprising:
an organic light-emitting layer forming step of forming the organic light-emitting layer by applying an ink comprising an organic light-emitting material to the inside of a partition wall built to surround a pixel region for forming a pixel; and
a surface treating step of treating a surface before the organic light-emitting layer forming step with an organic solvent from the side where the partition wall is built with respect to the substrate.

2. The method of producing an organic electroluminescent element according to claim 1, wherein the step of treating the surface is a step of bringing the organic solvent into contact with the surface from the side where the partition wall is built with respect to the substrate.

3. The method of producing an organic electroluminescent element according to claim 2, wherein the organic solvent is brought into contact with the surface from the side where the partition wall is built with respect to the substrate, by using a spin coating method, in the step of treating the surface.

4. The method of producing an organic electroluminescent element according to claim 2, wherein the step of treating the surface comprises drying the organic solvent after the organic solvent is brought into contact with the surface.

5. The method of producing an organic electroluminescent element according to claim 1, wherein the organic solvent comprises one or two or more of solvents for an ink.

6. The method of producing an organic electroluminescent element according to claim 1, wherein the organic solvent comprises one or two or more of solvents for the organic light-emitting material.

7. The method of producing an organic electroluminescent element according to claim 1, wherein the organic solvent is anisole.

8. The method of producing an organic electroluminescent element according to claim 1, wherein the ink comprising the organic light-emitting material is applied to the inside of the partition wall by a printing method, in the step of forming the organic light-emitting layer.

9. The method of producing an organic electroluminescent element according to claim 8, wherein the printing method is a flexographic printing method.

10. The method of producing an organic electroluminescent element according to claim 1, further comprising an interlayer forming step of forming an organic material layer in the pixel region before the surface treating step.

11. An organic electroluminescent element obtained by the method of producing an organic electroluminescent element according to claim 1.

12. A display device comprising the organic electroluminescent element according to claim 11.
